# EUROPEAN PATENT APPLICATION

(11) **EP 4 418 534 A1**
(43) Date of publication of application: **21.08.2024**
(21) Application number: 22885693.6
(22) Date of filing: 13.10.2022
(51) Int. Cl.: H02S 30/20, H01L 31/04

(54) **FLEXIBLE FOLDABLE PHOTOVOLTAIC ASSEMBLY AND PREPARATION METHOD THEREFOR**

(30) Priority: 31.10.2021 CN 202111278920
(71) Applicant: Cando-Solarphotoelectric Technology (Changzhou) Co., Ltd, Changzhou City, Jiangsu 213000 (CN)
(72) Inventor: HUANG, Yaolun, Changzhou City, Jiangsu 21300 (CN)
(74) Representative: Schmid, Nils T.F.
(86) International application number: PCT/CN2022/125092
(87) International publication number: WO 2023/071814

(57) **Abstract**

The present invention relates to a flexible foldable photovoltaic assembly and a preparation method therefor. The assembly comprises a flexible packaging structure, a hard protection plate, and a photovoltaic cell layer; the hard protection plate is provided with flexible folding lines, the assembly is divided into a plurality of folding units by means of the flexible folding lines, and photovoltaic cells of the photovoltaic cell layer are located in the folding units. When the assembly is in a normal operating state, a folding included angle A is formed between adjacent folding units. The preparation method for the assembly comprises: before the assembly is laminated, patterning the hard protection plate to form the flexible folding lines, and then performing laying out and lamination. The beneficial effects are that: according to the design of the flexible folding lines in the present invention, the hard protection plate is still a whole block before lamination while being capable of being folded, automatic operation is facilitated, the production efficiency of the assembly can be greatly improved, and the production cost is reduced. Furthermore, by designing the folding included angle A between the adjacent folding units, the efficiency of the assembly can be greatly improved.

## Description

### TECHNICAL FIELD

The present disclosure relates to the technical field of photovoltaics, and particularly to a flexible foldable photovoltaic module (assembly) and a preparation method therefor.

### BACKGROUND ART

With general emphasis on climate crisis at home and abroad, all countries have proposed specific target time points of "carbon peak" and "carbon neutralization". Photovoltaic products have rapidly turned from predominantly large-scale power station applications to distributed applications, and their combination with civil life scenarios such as buildings and electric automobiles have been accelerated. Internationally, for directions such as combination with buildings and with new energy vehicles, the International Energy Agency (IEA) organized global technical experts to set up relevant joint working group. In China, the Energy Administration of National Development and Reform Commission put forward the idea of "whole county promotion", which also greatly accelerates the speed of combination of photovoltaics and civil life scenarios.

New photovoltaic application scenarios put forward higher requirements on improving the photoelectric conversion efficiency of the photovoltaic products, thereby improving power generation per unit area.

Group III-V compound cells (GaAs), as well as stacked and multi-junction cells (Tandem) occupy a small part of special application markets that have high requirements on module efficiency and high price tolerance. On the one hand, the photoelectric conversion efficiency of these products is far ahead of that of ordinary modules, wherein the efficiency of ordinary modules is 20-22%, and the conversion efficiency of these special products may reach 30% or more. However, the high price of these products also limits applications of these efficient photovoltaic products.

Chinese patent document CN20948696U discloses a foldable solar power generation device, an emergency power supply system and a mobile power supply vehicle, including a Miura folding frame, a plurality of photovoltaic cell panels and a driving mechanism for driving the Miura folding frame, wherein the plurality of photovoltaic cell panels are mounted on the Miura folding frame for unfolding and folding.

Chinese patent document CN206977375U discloses a hinge-type photovoltaic module, including two or more rectangular base plates having solar cell chips, wherein the rectangular base plates are connected by a hinge, so that the photovoltaic module is foldable.

The technical solutions disclosed in the above two patent documents have the following disadvantages: the folded photovoltaic cells are not a whole photovoltaic module, and installation cost of the whole device is high.

Chinese patent CN102945873A discloses a multi-dimensional folded flexible solar cell module and a manufacturing method therefor, wherein a photovoltaic cell in the module is a flexible photovoltaic cell, specifically an amorphous silicon thin film solar cell, and a local protection layer is added for protecting the flexible photovoltaic cell.

The disadvantage thereof is as follows: according to the existing module manufacturing method, the protection layer is laid out above corresponding photovoltaic cells in a layout step, and because the protection layer is of a split type, it is not conducive to automatic production of the module, the production cost is high, and it is not beneficial to mass production.

### SUMMARY

The technical problem to be solved by the present disclosure is to provide a flexible foldable photovoltaic module and a preparation method therefor, so as to reduce the production cost of the flexible module.

Technical solutions used in the present disclosure for solving the technical problem thereof are as follows: a flexible foldable photovoltaic module, including a flexible encapsulation structure, and a hard protection plate and a photovoltaic cell layer which are encapsulated in the flexible encapsulation structure, wherein the hard protection plate is configured to protect photovoltaic cells in the photovoltaic cell layer, the hard protection plate is provided with flexible folding lines, so that the flexible foldable photovoltaic module is capable of being flexibly folded along the flexible folding lines, wherein the flexible foldable photovoltaic module is divided into a plurality of folding units through the flexible folding lines, and the photovoltaic cells in the photovoltaic cell layer are located within the folding units.

In order to improve the photoelectric conversion efficiency of the module, it is further defined that when the module is in a normal operating state, a folding included angle A is formed between adjacent folding units.

The folding included angle may be customized according to environmental conditions, and generally, the folding included angle A is 50-70 degrees.

It is further defined that the flexible foldable photovoltaic module further includes a module outer frame around the encapsulation structure, for maintaining the folding included angle A between adjacent folding units; or
the flexible foldable photovoltaic module further includes a hard back plate on a back side of the flexible encapsulation structure, for maintaining the folding included angle A between adjacent folding units; or
the flexible foldable photovoltaic module further includes a folding and unfolding mechanism of the module is further included, for adjusting the folding included angle A between adjacent folding units by unfolding or folding the flexible foldable photovoltaic module.

It is further defined that parts of the flexible encapsulation structure corresponding to the flexible folding lines have a folding stress, so that the folding units is folded along the flexible folding lines in a preset folding direction under effect of the folding stress.

It is further defined that the flexible folding lines on the hard protection plate are specifically formed by intermittent points and/or intermittent lines; alternatively, the flexible folding lines on the hard protection plate are specifically thinned regions of the hard protection plate.

It is further defined that the photovoltaic cells in adjacent folding units are interconnected through flexible conductors, and the flexible conductors are metal foil conductive bands, conductive paste bands or flexible flat cables.

It is further defined that the flexible foldable photovoltaic module is folded in a Miura folding structure, and the folding units are in a parallelogram shape.

Specifically, the photovoltaic cells in the folding units have the same shape as the folding units, and specifically are single parallelogram-shaped photovoltaic cells.

It is further defined that the flexible foldable photovoltaic module is folded in a w-folding structure; alternatively, the flexible foldable photovoltaic module is folded in a combined w-folding structure, wherein the combined w-folding structure is composed of at least three w-folding segments, adjacent w-folding segments are in an inverse-folding relationship with each other, the folding units in the w-folding segments at two ends are in a triangular shape, and the folding units in respective w-folding segments in a middle region are in a trapezoid shape.

Specifically, the photovoltaic cells in the trapezoid-shaped folding units have the same shape as the folding units, and specifically consist of at least one rectangular photovoltaic cell and two right-angled trapezoid-shaped photovoltaic cells, wherein the rectangular photovoltaic cells are arranged in a line to form a main part of a rectangle, and the two right-angled trapezoid-shaped photovoltaic cells are located at two sides of the main part of the rectangle, so as to form the trapezoid-shaped photovoltaic cell.

It is further defined that the flexible encapsulation structure includes a flexible face plate layer, a bonding layer, and a flexible back plate layer, and layer structures of the flexible foldable photovoltaic module from top to bottom are: the flexible face plate layer, the bonding layer, the hard protection plate, the bonding layer, the photovoltaic cell layer, the bonding layer and the flexible back plate layer, and the hard protection plate is made of glass, acrylic, glass fiber cloth or a fiber-reinforced composite material; and the flexible face plate layer and the flexible back plate layer are made of ETFE, TPO, PET, nylon or composite material thereof.

A preparation method for the above flexible foldable photovoltaic module, wherein before laminating the module, performing patterning on the hard protection plate, so as to form the flexible folding lines on the hard protection plate, then laying out the flexible encapsulation structure, the hard protection plate, and the photovoltaic cells, and after that, putting them into a laminator to complete lamination of the module.

It is further defined that the hard protection plate is patterned by means of mechanical cutting, punching or laser.

It is further defined that the flexible encapsulation structure is processed after the lamination of the module, and a folding stress is formed at parts of the flexible encapsulation structure corresponding to the flexible folding lines, so that the folding units are folded along the flexible folding lines in a preset folding direction under effect of the folding stress.

It is further defined that the flexible encapsulation structure is processed, and a folding stress is formed at parts of the flexible encapsulation structure corresponding to the flexible folding lines, wherein a specific method for forming the folding stress is as follows: processing the flexible encapsulation structure by means of one or a combination of laser, hot pressing, ray scanning, and patterned polymer doping.

It is further defined that before laminating the module, the photovoltaic cells are connected into a cell string through interconnecting conductors, then the photovoltaic cells are sliced into small photovoltaic cells through a slicing process, so as to obtain small cell strings formed by the small photovoltaic cells, for subsequent layout of the module.

It is further defined that a following method is used to obtain parallelogram-shaped small photovoltaic cells which are used as photovoltaic cells in the photovoltaic cell layer of the flexible foldable photovoltaic module folded in a Miura folding structure: trisection-slicing an orthohexagonal large photovoltaic cell with connecting lines from a center of the orthohexagonal large photovoltaic cell to vertexes as slicing lines;
alternatively, a following method is used to obtain a rectangular photovoltaic cell and a right-angled trapezoid-shaped photovoltaic cell which are used as the photovoltaic cells in the trapezoid-shaped folding units, wherein the photovoltaic cells in the trapezoid-shaped folding units have the same shape as the folding units, and specifically consist of at least one rectangular photovoltaic cell and two right-angled trapezoid-shaped photovoltaic cells, wherein the rectangular photovoltaic cells are arranged in a line to form a main part of a rectangle, and the two right-angled trapezoid-shaped photovoltaic cells are located at two sides of the main part of rectangle, so as to form the trapezoid-shaped photovoltaic cell: slicing a regular dodecagon-shaped large photovoltaic cell into a middle square-shaped small photovoltaic cell and four surrounding isosceles trapezoid-shaped small photovoltaic cells with four connecting lines between vertexes as the slicing lines, wherein a middle square-shaped small photovoltaic cell is sliced into rectangular photovoltaic cells, and the isosceles trapezoid-shaped small photovoltaic cells are sliced into right-angled trapezoid-shaped photovoltaic cells with connecting lines between middle points of upper and lower sides as the slicing lines

The beneficial effects of the present disclosure are as follows: according to the design of the flexible folding lines in the present disclosure, the hard protection plate can be still a whole piece before lamination while being folded, which facilitates automatic operation, can greatly improve the production efficiency of the module, and reduce the production cost.

Further, according to the design of forming the folding included angle A between adjacent folding units when the module is in the normal operating state, the efficiency of the module may be greatly improved. Without changing the structure of the photovoltaic cells, the photovoltaic conversion efficiency of the module per unit light receiving area is greatly improved, meeting high-efficiency market requirements rapidly.

Being suitable for all cell technology types: the technology of the present disclosure can greatly improve the photoelectric conversion efficiency of photovoltaic module products of all the known cell types at present.

Being beneficial to improve power generation: the design of the present disclosure is not only beneficial to improve the power generation of vertical incidence, but also beneficial to improve the power generation of inclination angles in the morning and evening, thereby reducing the photovoltaic power generation cost.

Being beneficial to reduce the cost: due to the foldable design of the module, a storage space of the module may be greatly compressed and logistic and storage costs are reduced. Installation and maintenance costs of the module also may be reduced. The installation is quick and simple, and the maintenance can be carried out by directly folding, rolling and cleaning even without going up to the roof.

Improving safety: as the present module design has a fast construction speed, the construction method is simple, and black cloth can be used to cover and shade the module, so that construction safety may be greatly promoted. If photovoltaic fire disaster occurs, the module also may be quickly folded in a short time, quickly shut itself down and shade itself, thereby powering off and extinguishing the fire.

### BRIEF DESCRIPTION OF DRAWINGS

The present disclosure is further illustrated below in conjunction with the drawings and embodiments.
FIG. 1 is a preparation flow chart according to Embodiment 1 of the present disclosure;
FIG. 2 is a structural schematic diagram of a patterned hard protection plate according to Embodiment 1 of the present disclosure;
FIG. 3 is a schematic diagram of a folding structure of a photovoltaic module according to Embodiment 1 of the present disclosure;
FIG. 4 is a schematic diagram of an unfolding structure showing photovoltaic cell layers according to Embodiment 1 of the present disclosure;
FIG. 5 is a structural schematic diagram of flexible folding lines according to Embodiment 1 of the present disclosure;
FIG. 6 is a structural schematic diagram of cutting dies for forming the flexible folding lines in FIG. 5 of the present disclosure;
FIG. 7 is a schematic diagram of forming a folding stress by laser according to Embodiment 1 of the present disclosure;
FIG. 8 is a schematic diagram of performing a simulation test in the present disclosure;
FIG. 9 is a schematic diagram of an unfolding structure of a photovoltaic module according to Embodiment 4 of the present disclosure;
FIG. 10 is a structural schematic diagram of a patterned hard protection plate according to Embodiment 6 of the present disclosure;
FIG. 11 is a schematic diagram of a folding structure of a photovoltaic module according to Embodiment 6 of the present disclosure;
FIG. 12 is a structural schematic diagram of a patterned hard protection plate according to Embodiment 7 of the present disclosure;
FIG. 13 is a schematic diagram of a folding structure of a photovoltaic module according to Embodiment 7 of the present disclosure;
FIG. 14 is a schematic diagram of rectangular small photovoltaic cells obtained by slicing a square-shaped photovoltaic cell in the present disclosure;
FIG. 15 is a schematic diagram of parallelogram-shaped small photovoltaic cells obtained by slicing an orthohexagonal photovoltaic cell in the present disclosure;
FIG. 16 is a schematic diagram of small photovoltaic cells obtained by slicing an orthohexagonal photovoltaic cell in the present disclosure; and
FIG. 17 is a schematic diagram of a photovoltaic cell formed by the small photovoltaic cells obtained in FIG. 16 in a trapezoidal folding unit.

In the drawings, 1. flexible folding line, 2. folding unit, 3. photovoltaic cell, 4. flexible conductor, 5. welding strip, 6-1. upper cutting die, 6-2. lower cutting die, 7-1. mountain folding part, 7-2. valley folding part, 8. junction box, 9. slicing line, 10. hard protection plate, 11. laser-light processing device.

### DETAILED DESCRIPTION OF EMBODIMENTS

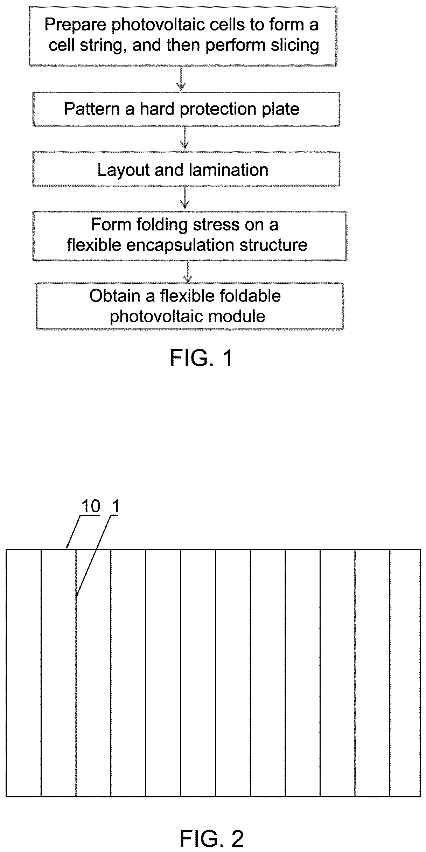

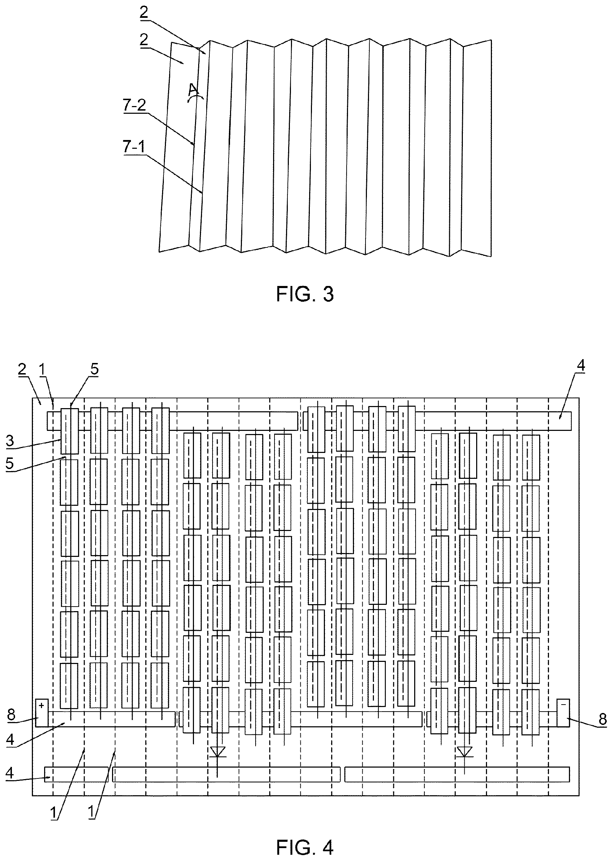

Embodiment 1: As shown in FIGS. 2, 3, 4 and 5, a flexible foldable photovoltaic module includes a flexible encapsulation structure, and a hard protection plate 10 and a photovoltaic cell layer encapsulated in the flexible encapsulation structure. The hard protection plate 10 is used to protect photovoltaic cells 3 in the photovoltaic cell layer. The hard protection plate 10 is provided with flexible folding lines 1, so that the flexible foldable photovoltaic module can be flexibly folded along the flexible folding lines 1. The flexible foldable photovoltaic module is divided into a plurality of folding units 2 through the flexible folding lines 1. The photovoltaic cells 3 in the photovoltaic cell layer are located within respective folding units 2.

When the module is in a normal operating state, folding included angle A is formed between adjacent folding units 2, wherein the folding included angle A is 50-70 degrees.

The flexible foldable photovoltaic module further includes a module outer frame around the encapsulation structure, for maintaining the folding included angle A between adjacent folding units 2. Alternatively, a hard back plate on a back side of the flexible encapsulation structure is further included, for maintaining the folding included angle A between adjacent folding units 2.

The flexible folding lines 1 on the hard protection plate 10 are specifically formed by intermittent points and/or intermittent lines.

Parts of the flexible encapsulation structure corresponding to the flexible folding lines 1 have a folding stress, so that the folding units 2 is folded along the flexible folding lines 1 in a preset folding direction under the effect of the folding stress.

The photovoltaic cells 3 in adjacent folding units 2 are interconnected through flexible conductors 4. The flexible conductors 4 are metal foil conductive bands, conductive paste bands or flexible flat cables. The flexible flat cables are FFC flat cables, FPC flat cables or PTF flat cables.

The folding units 2 are folded using a w-folding structure. The folding units 2 are rectangular. The folding direction is a width direction of the folding units 2. The folding units 2 are arranged side by side along the folding direction.

The photovoltaic cells 3 in the folding units 2 have the same shape as the folding units 2, and are formed by a plurality of rectangular photovoltaic cells 3 arranged in a line along a length direction. The rectangular photovoltaic cells 3 are small photovoltaic cells obtained by slicing a square-shaped large photovoltaic cell.

The flexible encapsulation structure includes a flexible face plate layer, a bonding layer, and a flexible back plate layer. Layer structures of the flexible foldable photovoltaic module from top to bottom are: the flexible face plate layer, the bonding layer, the hard protection plate 10, the bonding layer, the photovoltaic cell layer, the bonding layer and the flexible back plate layer. The hard protection plate 10 is made of glass, acrylic, glass fiber cloth or a fiber-reinforced composite material, and the flexible face plate layer and the flexible back plate layer are made of ETFE, TPO, PET, nylon or their composite material.

As shown in FIG. 1, a preparation method for the flexible foldable photovoltaic module of Embodiment 1 is as follows: before lamination of the module, performing patterning on the hard protection plate 10 by means of mechanical cutting, punching or laser, for forming the flexible folding lines 1 on the hard protection plate 10, then laying out the flexible encapsulation structure, the hard protection plate 10 and the photovoltaic cells 3, and after that, completing the lamination of the module in a laminator.

The flexible encapsulation structure is processed. A specific method for forming the folding stress at the parts of the flexible encapsulation structure corresponding to the flexible folding lines 1 is as follows: processing the flexible encapsulation structure by means of one or a combination of laser, hot pressing, ray scanning, and patterned polymer doping.

When the folding stress is formed by means of laser, hot pressing, or ray scanning, preferably, the step of forming the folding stress is after the lamination step, wherein the flexible encapsulation structure is processed after the lamination of the module, and the folding stress is formed at the parts of the flexible encapsulation structure corresponding to the flexible folding lines 1, so that the folding units 2 are folded along the flexible folding lines 1 in the preset folding direction under the effect of the folding stress.

When the folding stress is formed by the patterned polymer doping method, preferably, the step of forming the folding stress is before the lamination step.

Before the lamination of the module, after the photovoltaic cells 3 are connected to form a cell string through interconnecting conductors, the photovoltaic cells 3 are sliced into small photovoltaic cells through a slicing process, so as to obtain small cell strings formed by the small photovoltaic cells, for subsequent layout of the module.

Embodiment 1 is further described below by taking a PERC or TOPCON high-efficiency square-shaped large photovoltaic cell prepared by slicing a conventionally sliced 210 mm square silicon wafer according to a conventional cell process as an example.

The preparation method for the flexible foldable photovoltaic module of Embodiment 1 specifically includes the following steps:

S 1, first, a plurality of 210 mm square-shaped photovoltaic cells 3 are series-welded by welding strips 5 into a cell string using a conventional series welding device, wherein there are ten welding strips 5 on front sides and back sides of the photovoltaic cells 3 respectively. Each square-shaped photovoltaic cell 3 in the cell string is cut into ten 21*210 mm rectangular small photovoltaic cells by a laser slicing method, so as to obtain small cell strings formed by the rectangular small photovoltaic cells, wherein a laser slicing direction is parallel to a direction of the welding strips 5.

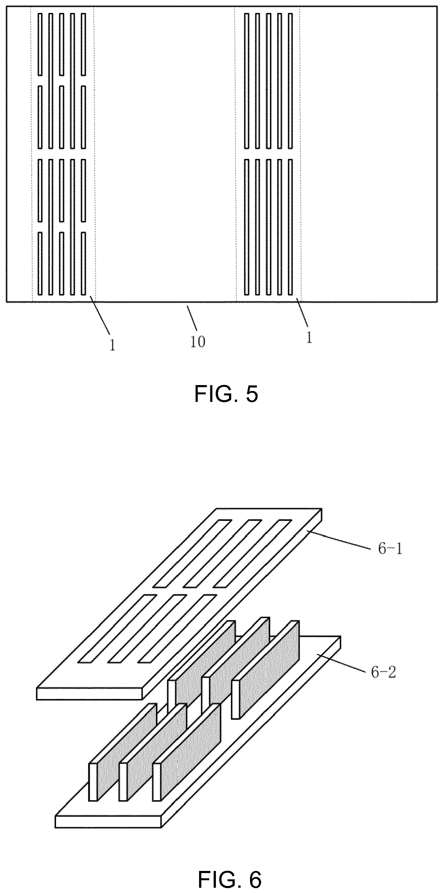

S2, patterning is performed on the hard protection plate 10: a fiber-reinforced composite material (FRP) obtained by compounding and hot-pressing acrylic and glass fibers is taken as the hard protection plate 10, the hard protection plate 10 is mechanically punched and processed using a mechanical punching tool composed of an upper cutting die 6-1 and a lower cutting die 6-2 as shown in FIG. 6, to realize the patterning of the hard protection plate 10, and flexible folding lines 1 are formed on the hard protection plate 10, wherein the flexible folding lines 1 are specifically formed by intermittent points and/or intermittent lines, as shown in FIG. 5.

S3, layout: first, the flexible back plate layer is laid on a layout workbench, then the bonding layer is laid, the flexible conductors 4 and the small cell strings are laid on the bonding layer, wherein each small cell string is located in one folding unit 2, a distance between the small cell strings is 3 mm, and the flexible conductors 4 are used for bus connection at two ends of the small cell strings, so as to form an electrically connected photovoltaic cell layer. The bonding layer, the hard protection plate 10, the bonding layer, and the flexible face plate layer are successively laid on the photovoltaic cell layer, so as to complete the layout of the module. The flexible face plate layer is specifically an ETFE film layer, and the bonding layer is specifically an EVA bonding layer.

S4, after the layout, the above layer structures is put into a laminator to complete lamination of the module.

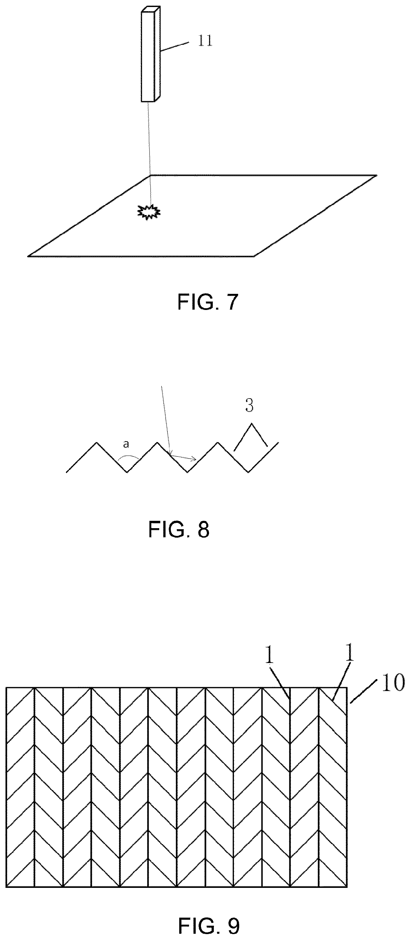

S5, the folding stress is formed at the parts of the flexible encapsulation structure corresponding to the flexible folding lines 1 by a laser-light processing method, the laser-light processing device 11 generates a high temperature on a partial surface of the flexible encapsulation structure of module laminate by controlling wavelength and light intensity of the laser, and generates the folding stress partially on the module, as shown in FIG. 7.

The module of Embodiment 1 is folded in the w-folding structure. Folding parts along the flexible folding lines 1 are divided into mountain folding parts 7-1 and valley folding parts 7-2. The mountain folding and valley folding are terms in the technical field of origami. The mountain folding forms a mountain-like fold, and the valley folding forms a valley-like fold.

In order to form the folding stress on both a front side and a back side of the module laminate, the folding units 2 are folded along the flexible folding lines 1 in a mountain folding direction and a valley folding direction under the effect of the folding stress. In order to improve the efficiency, the laser processing device 11 is provided on both the front side and the back side of the module laminate. The laser processing device located on the front side of the module laminate produces a high temperature on surfaces of the valley folding parts 7-2 of the flexible face plate layer of the module laminate along the flexible folding lines 1 and causes shrinkage, and generates the folding stress at the valley folding parts 7-2 of the module laminate, so that the folding units 2 are folded along the flexible folding lines 1 in the valley folding direction under the effect of the folding stress.

Likewise, the laser-light processing device located on the back side of the module laminate produces a high temperature on surfaces of the mountain folding parts 7-1 of the flexible back plate layer of the module laminate along the flexible folding lines 1 and causes shrinkage, and generates the folding stress at the mountain folding parts 7-1 of the module laminate, so that the folding units 2 are folded along the flexible folding lines 1 in the mountain folding direction under the effect of the folding stress.

S6, a junction box 8 and a connector are mounted to the above module laminate through a conventional process, so as to complete manufacture of the flexible foldable photovoltaic module.

The above module can be fixed by a corrugated plate having a corrugated fixture of 50-70 degrees as the hard back plate, so that the folding included angle A between adjacent folding units 2 remain unchanged. Alternatively, the module outer frame is mounted around the above module laminate, so that the folding included angle A between adjacent folding units 2 remain unchanged.

According to the design of the flexible folding lines 1 in Embodiment 1, the hard protection plate 10 can be still a whole piece before lamination while being folded, which facilitates automatic operation. The design of the folding stress enables the present flexible folding module to be always folded according to the preset folding structure during the unfolding and folding.

The hard back plate and the module outer frame may be installed at application sites of the module, and the module is subjected to storage and logistics in a completed folded state, which may reduce logistic and storage costs.

A conventional module is designed as a flat panel, and once illuminated by light, it will generate power; therefore, during the installation of the module, the module needs to be covered and shielded by black cloth, thereby preventing live installation of the module which causes an electric shock accident. The flexible foldable photovoltaic module in Embodiment 1 may be completely folded, so that the module does not generate power, and after electrical connection of the module is completed, the hard back plate and the module outer frame are installed, and the folding included angle A is locked, which helps to ensure personal safety of installation workers, reduce requirements on worker skills and knowledge training, thus reducing costs, and increasing usability of system.

As the folding included angle A is formed between adjacent folding units 2 when the module is in a normal operating state, wherein the folding included angle A is 50-70 degrees, light has multiple chances of being incident on surfaces of the photovoltaic cells 3 and absorbed, which may improve the efficiency of the photovoltaic module.

Sunny day outdoor simulation test is carried out, and a simulation test structure is as shown in FIG. 8.

A simulation test process is as follows: two half ordinary photovoltaic cells 3 are connected in series, then placed outdoors facing the sun, and the two photovoltaic cells 3 form an isosceles triangle. An included angle a between the cells is changed to test current intensity change of the photovoltaic cells, so as to test power change thereof. Then folded efficiency gain is obtained by dividing the power change by an equivalent area.

Test results are as shown in the following table:

| Setting | Horizontal, i.e., included angle a=180 degrees | Included angle a=60 degrees | Included angle a=65 degrees |
|---|---|---|---|
| Voltage | 100% | 100% | 100% |
| Current intensity | 100% | 176% | 173% |
| Module efficiency | 100% | 176% | 173% |

It can be found from simulation that the current generated per unit shoot-through light receiving area of the photovoltaic product is increased by about 70%. Considering that Joule loss in current transmission is unchanged, the efficiency of the photovoltaic module is also improved by 70%. That is to say, the module efficiency of the photovoltaic module product using this design is greatly improved.

Embodiment 2, substantially the same as Embodiment 1, differs in that the flexible foldable photovoltaic module further includes a folding and unfolding mechanism of the module, for adjusting the folding included angle A between adjacent folding units 2 to change between 0 degrees and 180 degrees, by unfolding or folding the flexible foldable photovoltaic module.

When the module is in an operating state, the flexible foldable photovoltaic module may be opened to have a certain folding included angle A through the folding and unfolding mechanism of the module.

For the folding included angle of the flexible foldable photovoltaic module having the folding and unfolding mechanism, the folding included angle A may be adjusted according to environmental conditions, and power generation of inclination angle in the morning and evening also can be improved by adjusting the folding included angle A, thereby reducing the photovoltaic power generation cost. The folding included angle A between adjacent folding units 2 is generally 50-70 degrees.

In addition to the advantages of Embodiment 1, Embodiment 2 also has other advantages. For example, when the module encounters a safety risk, for example, when encounters fire, the folding and unfolding mechanism of the module may be activated to completely fold the flexibly folded photovoltaic module, so that the photovoltaic module immediately stop generate power, photovoltaic device is completely powered off, and thus life safety of firefighters is protected quite intuitively.

Embodiment 3, substantially the same as Embodiment 2, differs in that the flexible folding lines 1 on the hard protection plate 10 specifically are thinned regions of the hard protection plate 10. Preferably, the thinned regions are formed by laser processing. However, mechanically forming the thinned regions is not excluded.

Embodiment 4, substantially the same as Embodiment 2, differs in that the flexible foldable photovoltaic module is folded in a Miura folding structure, and that the folding units 2 are in a parallelogram shape. FIG. 9 is a structural schematic diagram of the hard protection plate 10 for Miura folding.

The shape of the photovoltaic cells 3 in the folding units 2 is the same as that of the folding units 2, and the photovoltaic cells 3 in the folding units 2 are small photovoltaic cells formed by slicing a square heterojunction HJT cell according to the flexible folding lines 1.

The advantage of the Miura folding structure is that ability of a surface of the module to withstand pressure is improved, because the Miura folding structure has more balanced support points, and meanwhile the folding included angles A between all adjacent folding units 2 in the module are more easy to be consistent. The Miura folding structure also may be fully folded and fully unfolded.

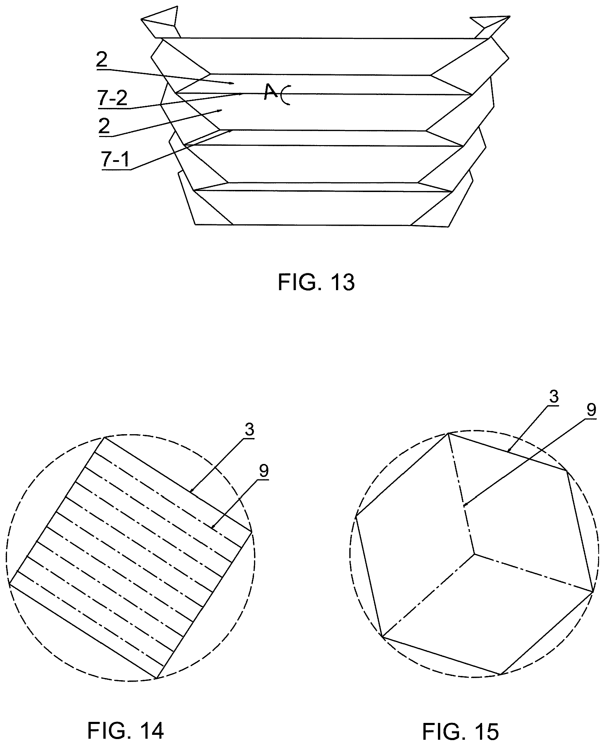

Embodiment 5, substantially the same as Embodiment 4, differs in that the photovoltaic cells 3 in the folding units 2 are specifically single parallelogram-shaped photovoltaic cells 3. The single parallelogram-shaped photovoltaic cells 3 are parallelogram-shaped small photovoltaic cells obtained by trisection-slicing an orthohexagonal large photovoltaic cell with connecting lines from a center of the orthohexagonal large photovoltaic cell to vertexes as slicing lines 9, as shown in FIG. 15.

The orthohexagonal large photovoltaic cell specifically is an orthohexagonal TOPCON cell. A conventional slicing manner for producing ingots of the photovoltaic cells 3 is to slice a silicon wafer into a square shape, as shown in FIG. 14. However, in Embodiment 5, the silicon wafer is sliced into an orthohexagonal shape internally tangent with the ingot, and thus compared with the square silicon wafer, the manufactured photovoltaic cells 3 have a larger area.

Since the manufacturing processes of the TOPCON silicon wafer and the cells mostly use furnace tubes, using the orthohexagonal silicon wafer to manufacture the cells may improve the throughput of the whole process by 30%, that is, the manufacturing cost may be reduced by about 30%. For TOPCON cells, it means significant cost reduction of 4-5 cents per watt. The photovoltaic cells 3 using the furnace tube process, such as PERC cells, polycrystalline cells, and TOPCON cells, may all have the same benefit.

As shown in FIG. 15, three parallelogram-shaped small photovoltaic cells can be cut out from one orthohexagonal large photovoltaic cell without any waste.

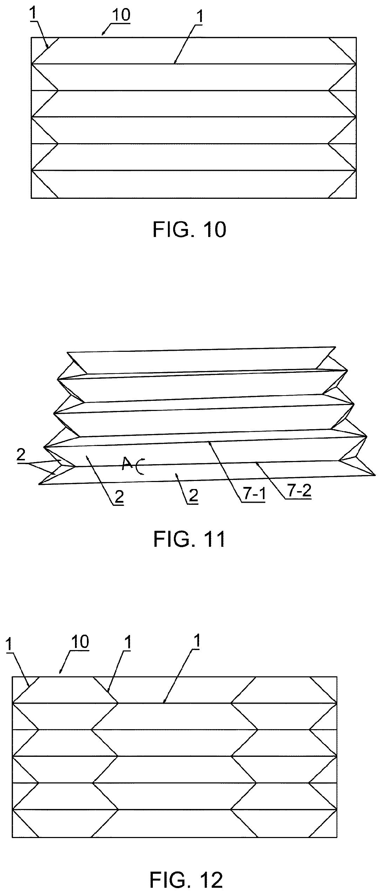

Embodiment 6, substantially the same as Embodiment 2, differs in that the flexible foldable photovoltaic module is folded in a combined w-folding structure. The combined w-folding structure is composed of three w-folding segments, wherein adjacent w-folding segments are in an inverse-folding relationship with each other, the folding units 2 in the w-folding segments at two ends are in a triangular shape, and the folding units 2 in the w-folding segments in a middle region are in a trapezoid shape, specifically as shown in FIG. 10 and FIG. 11.

The w-folding segments at two ends, compared with the ordinary w-folding structures of Embodiments 1 and 2, can make the combined w-folding structure of Embodiment 6 improve the ability of the surface of the module to withstand pressure, and meanwhile, the folding included angles A between all adjacent folding units 2 in the module are easier to keep consistent.

The shape of the photovoltaic cells 3 in the folding units 2 are the same as that of the folding units 2.

The photovoltaic cells 3 in the triangle-shaped folding units 2 of the w-folding segments at the two ends may be omitted, or replaced with silicon dummy wafers or plastic dummy wafers.

The photovoltaic cells 3 in the trapezoid-shaped folding units 2 specifically consist of at least one rectangular photovoltaic cell 3 and two right-angled trapezoid-shaped photovoltaic cells 3, wherein the rectangular photovoltaic cells 3 are arranged in a line to form a main part of the rectangle, and the two right-angled trapezoid-shaped photovoltaic cells 3 are located at two sides of the main part of the rectangle to form the trapezoid-shaped photovoltaic cell 3.

When the photovoltaic cells 3 in the triangle-shaped folding units 2 are omitted or replaced with silicon dummy wafers or plastic dummy wafers, the small photovoltaic cells in all shapes of Embodiment 6 may be obtained by slicing a regular dodecagon-shaped large photovoltaic cell.

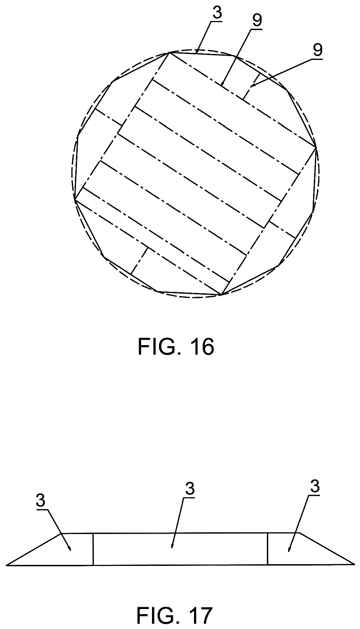

The rectangular photovoltaic cells 3 and the right-angled trapezoid-shaped photovoltaic cells 3 in the trapezoid-shaped folded units 2 are small photovoltaic cells obtained by slicing a regular dodecagon-shaped large photovoltaic cell. A slicing scheme for slicing the small photovoltaic cells is as shown in FIG. 16, in which dotted lines are slicing lines 9. The regular dodecagon-shaped large photovoltaic cell is sliced into a middle square-shaped small photovoltaic cell and four surrounding isosceles trapezoid-shaped small photovoltaic cells with four connecting lines between vertexes as the slicing lines 9. The middle square-shaped small photovoltaic cell is further sliced into rectangular photovoltaic cells 3, and the isosceles trapezoid-shaped small photovoltaic cells are further sliced into right-angled trapezoid-shaped small photovoltaic cells 3 with connecting lines between middle points of upper and lower sides as the slicing lines 9.

A regular dodecagon-shaped large photovoltaic cell is sliced according to the slicing lines 9 as shown in FIG. 16, so that eight right-angled trapezoid-shaped photovoltaic cells 3 and five rectangular photovoltaic cells 3 with the same size and one slightly smaller rectangular photovoltaic cell 3 may be obtained in total. The slightly smaller rectangular photovoltaic cell 3 will not be wasted, and may be used for producing photovoltaic modules of conventional specification. The two right-angled trapezoid-shaped photovoltaic cells 3 and one rectangular photovoltaic cell 3 may constitute a trapezoid-shaped photovoltaic cell 3, as shown in FIG. 17.

When the regular dodecagon-shaped large photovoltaic cell specifically is a regular dodecagon-shaped TOPCON cell, a conventional slicing manner for producing ingots of the photovoltaic cells 3 is to slice a silicon wafer into a square shape, as shown in FIG. 14. However, in Embodiment 6, the silicon wafer is sliced into a regular dodecagon shape internally tangent with the ingot, and thus compared with the square-shaped silicon wafer, the manufactured photovoltaic cells 3 have a larger area.

Since the manufacturing processes of the TOPCON silicon wafer and the cells mostly use furnace tubes, using the regular dodecagon-shaped silicon wafer to manufacture the cells may improve the throughput of the whole process by 50%, that is, the manufacturing cost may be reduced by about 50%. For TOPCON cells, it means significant cost reduction of 7 cents per watt. The photovoltaic cells 3 using the furnace tube process, such as PERC cells, polycrystalline cells, and TOPCON cells, may all have the same benefit.

Embodiment 7, substantially the same as Embodiment 6, with the flexible foldable photovoltaic module being likewise folded using a combined w-folding structure, differs in that as shown in FIGS. 12 and 13, the combined w-folding structure is composed of five w-folding segments, wherein adjacent w-folding segments are in an inverse-folding relationship with each other, the folding units 2 in the w-folding segments at two ends are in a triangular shape, and the folding units 2 in the three w-folding segment in a middle region are in a trapezoid shape.

The w-folding segments located at two ends can make the combined w-folding structure of Embodiment 7 improve the ability of the surface of the module to withstand pressure, compared with the ordinary w-folding structures of Embodiments 1 and 2, and meanwhile, the folding included angles A between all adjacent folding units 2 in the module are easier to keep consistent.

The three w-folding segments located in the middle region make the module form three light receiving surfaces having certain included angles, so as to adapt to a three-dimensional module installation plane having three planes.

Embodiment 8, compared with Embodiment 1, differs in omitting a processing step of forming the folding stress on the flexible encapsulation structure.

Compared with the prior art, Embodiment 8 still has the following advantages: the hard protection plate 10 can be still a whole piece before lamination while being folded, which facilitates automatic operation,

The scope of protection of the present disclosure is not limited to the above embodiments. Based on the innovative idea of the present disclosure, new embodiments further may be formed by changing the cells to be GaAs cells, CdTe cells, CIGS cells, perovskite cells or other stacked cells, changing the folding structure, changing the processing mode of patterning the hard protection plate 10, and changing the processing mode of forming the folding stress on the flexible encapsulation structure are all suitable for the scope of protection of the present disclosure.

## Claims

1. A flexible foldable photovoltaic module, **characterized by** comprising: a flexible encapsulation structure, and a hard protection plate and a photovoltaic cell layer which are encapsulated in the flexible encapsulation structure, wherein the hard protection plate is configured to protect photovoltaic cells in the photovoltaic cell layer, and
the hard protection plate is provided with flexible folding lines, so that the flexible foldable photovoltaic module is capable of being flexibly folded along the flexible folding lines, wherein the flexible foldable photovoltaic module is divided into a plurality of folding units through the flexible folding lines, and the photovoltaic cells in the photovoltaic cell layer are located within folding units.

2. The flexible foldable photovoltaic module according to claim 1, wherein when the module is in a normal operating state, a folding included angle A is formed between adjacent folding units.

3. The flexible foldable photovoltaic module according to claim 2, wherein the folding included angle A is 50-70 degrees.

4. The flexible foldable photovoltaic module according to claim 1 or 2, wherein the flexible foldable photovoltaic module further comprises a module outer frame around the encapsulation structure, for maintaining the folding included angle A between adjacent folding units; or
the flexible foldable photovoltaic module further comprises a hard back plate on a back side of the flexible encapsulation structure, for maintaining the folding included angle A between adjacent folding units; or
the flexible foldable photovoltaic module further comprises a folding and unfolding mechanism of the module, for adjusting the folding included angle A between adjacent folding units by unfolding or folding the flexible foldable photovoltaic module.

5. The flexible foldable photovoltaic module according to any one of claims 1-4, wherein parts of the flexible encapsulation structure corresponding to the flexible folding lines have a folding stress, so that the folding units is folded along the flexible folding lines in a preset folding direction under effect of the folding stress.

6. The flexible foldable photovoltaic module according to claim 1, wherein the flexible folding lines on the hard protection plate are specifically formed by intermittent points and/or intermittent lines;
alternatively, the flexible folding lines on the hard protection plate are specifically thinned regions of the hard protection plate.

7. The flexible foldable photovoltaic module according to claim 1, wherein the photovoltaic cells in adjacent folding units are interconnected through flexible conductors, and the flexible conductors are metal foil conductive bands, conductive paste bands or flexible flat cables.

8. The flexible foldable photovoltaic module according to claim 1, wherein the flexible foldable photovoltaic module is folded in a Miura folding structure, and the folding units are in a parallelogram shape.

9. The flexible foldable photovoltaic module according to claim 8, wherein the photovoltaic cells in the folding units have the same shape as the folding units, and specifically are single parallelogram-shaped photovoltaic cells.

10. The flexible foldable photovoltaic module according to claim 1, wherein the flexible foldable photovoltaic module is folded in a w-folding structure;
alternatively, the flexible foldable photovoltaic module is folded in a combined w-folding structure, wherein the combined w-folding structure is composed of at least three w-folding segments, adjacent w-folding segments are in an inverse-folding relationship with each other, the folding units in the w-folding segments at two ends are in a triangular shape, and the folding units in respective w-folding segments in a middle region are in a trapezoid shape.

11. The flexible foldable photovoltaic module according to claim 10, wherein the photovoltaic cells in the trapezoid-shaped folding units have the same shape as the folding units, and specifically consist of at least one rectangular photovoltaic cell and two right-angled trapezoid-shaped photovoltaic cells, wherein the rectangular photovoltaic cells are arranged in a line to form a main part of a rectangle, and the two right-angled trapezoid-shaped photovoltaic cells are located at two sides of the main part of the rectangle, so as to form the trapezoid-shaped photovoltaic cell.

12. The flexible foldable photovoltaic module according to claim 1, wherein the flexible encapsulation structure comprises a flexible face plate layer, a bonding layer, and a flexible back plate layer, and layer structures of the flexible foldable photovoltaic module from top to bottom are: the flexible face plate layer, the bonding layer, the hard protection plate, the bonding layer, the photovoltaic cell layer, the bonding layer and the flexible back plate layer; and
the hard protection plate is made of glass, acrylic, glass fiber cloth or a fiber-reinforced composite material, and the flexible face plate layer and the flexible back plate layer are made of ETFE, TPO, PET, nylon or composite material thereof.

13. A preparation method for the flexible foldable photovoltaic module according to claim 1, **characterized by** before laminating the module, performing patterning on the hard protection plate, so as to form the flexible folding lines on the hard protection plate, then laying out the flexible encapsulation structure, the hard protection plate, and the photovoltaic cells, and after that, putting them into a laminator to complete lamination of the module.

14. The preparation method for the flexible foldable photovoltaic module according to claim 13, wherein the hard protection plate is patterned by means of mechanical cutting, punching or laser.

15. The preparation method for the flexible foldable photovoltaic module according to claim 13, wherein the flexible encapsulation structure is processed after the lamination of the module, and a folding stress is formed at parts of the flexible encapsulation structure corresponding to the flexible folding lines, so that the folding units are folded along the flexible folding lines in a preset folding direction under effect of the folding stress.

16. The preparation method for the flexible foldable photovoltaic module according to claim 13, wherein the flexible encapsulation structure is processed, and a folding stress is formed at parts of the flexible encapsulation structure corresponding to the flexible folding lines, wherein a specific method for forming the folding stress is as follows: processing the flexible encapsulation structure by means of one or a combination of laser, hot pressing, ray scanning, and patterned polymer doping.

17. The preparation method for the flexible foldable photovoltaic module according to claim 13, wherein before laminating the module, the photovoltaic cells are connected into a cell string through interconnecting conductors, then the photovoltaic cells are sliced into small photovoltaic cells through a slicing process, so as to obtain small cell strings formed by the small photovoltaic cells, for subsequent layout of the module.

18. The preparation method for the flexible foldable photovoltaic module according to claim 13, wherein a following method is used to obtain parallelogram-shaped small photovoltaic cells which are used as photovoltaic cells in the photovoltaic cell layer of the flexible foldable photovoltaic module folded in a Miura folding structure: trisection-slicing an orthohexagonal large photovoltaic cell with connecting lines from a center of the orthohexagonal large photovoltaic cell to vertexes as slicing lines;
alternatively, a following method is used to obtain a rectangular photovoltaic cell and a right-angled trapezoid-shaped photovoltaic cell which are used as the photovoltaic cells in the trapezoid-shaped folding units, wherein the photovoltaic cells in the trapezoid-shaped folding units have the same shape as the folding units, and specifically consist of at least one rectangular photovoltaic cell and two right-angled trapezoid-shaped photovoltaic cells, wherein the rectangular photovoltaic cells are arranged in a line to form a main part of a rectangle, and the two right-angled trapezoid-shaped photovoltaic cells are located at two sides of the main part of rectangle, so as to form the trapezoid-shaped photovoltaic cell: slicing a regular dodecagon-shaped large photovoltaic cell into a middle square-shaped small photovoltaic cell and four surrounding isosceles trapezoid-shaped small photovoltaic cells with four connecting lines between vertexes as the slicing lines, wherein a middle square-shaped small photovoltaic cell is sliced into rectangular photovoltaic cells, and the isosceles trapezoid-shaped small photovoltaic cells are sliced into right-angled trapezoid-shaped photovoltaic cells with connecting lines between middle points of upper and lower sides as the slicing lines.
